# EUROPÄISCHE PATENTANMELDUNG

(11) **EP 1 094 469 A1**
(43) Veröffentlichungstag der Anmeldung: **25.04.2001**
(21) Anmeldenummer: 99121161.6
(22) Anmeldetag: 22.10.1999
(51) Int. Cl.: G11C 11/22, G11C 29/00

(54) **Anordnung zur Auswertung eines aus einem ferroelektrischen Speicherkondensator ausgelesenen Signales**

(71) Anmelder: Infineon Technologies AG, 81669 München (DE)
(72) Erfinder: Bruecklmeier, Eric-Roger, 80634 München (DE); Bollu, Michael, Dr., 81671 München (DE); Schlager, Tobias, 8010 Graz (AT)
(74) Vertreter: Zedlitz, Peter, Dipl.-Inf.

(57) **Zusammenfassung**

Die Erfindung betrifft eine Anordnung zur Auswertung eines aus einem ferroelektrischen Speicherkondensator ausgelesenen Signales, bei der zusätzlich zu einem Zustand positiver Polarisation und negativer Polarisation noch ein Zustand schwacher Polarisation ("X") ausgewertet wird, wodurch die Datenhaltungseigenschaft der Speicherzellen überprüft und ein Manipulationsversuch nachgewiesen werden kann.

## Beschreibung

Die vorliegende Erfindung betrifft eine Anordnung zur Auswertung eines aus einem ferroelektrischen Speicherkondensator ausgelesenen Signales, mit einem Leseverstärker zum Verstärken des ausgelesenen Signales und einer dem Leseverstärker nachgeschalteten Auswertelogik.

Ferroelektrische Speicher sind bekanntlich aufgrund der Hystereseeigenschaft des ferroelektrischen Dielektrikums des Speicherkondensators nichtflüchtige Speicher, die Information über lange Zeit auch ohne angelegte Versorgungsspannung zu halten vermögen. In solchen ferroelektrischen Speichern wird die Information in der Form eines remanenten Polarisationszustandes des ferroelektrischen Dielektrikums gespeichert. Derzeit können so zwei Zustände gespeichert werden, die durch eine positive bzw. eine negative Polarisierung repräsentiert sind und denen eine "1" bzw. "0" zugeordnet ist.

Das Auslesen von Speicherzellen eines solchen Speichers erfolgt zum Beispiel durch einen Vergleich mit einer Referenzzelle, deren Zustand bekannt sein muß. So hat beispielsweise bei Speicherzellen aus zwei Transistoren und zwei Kondensatoren (2T2C-Zelle) die Referenzzelle immer die zur Speicherzelle entgegengesetzte Polarisierung.

Der dem ferroelektrischen Speicher nachgeschaltete Leseverstärker arbeitet als Komparator, der die in einer zu lesenden Speicherzelle aufgenommene Ladungsmenge mit der Ladungsmenge der Referenzzelle bei Anlegen eines Lesepulses vergleicht. Die Zelle, deren Polarisierung umgeschaltet werden muß, nimmt dabei die größere Ladung auf.

Trägt am Beispiel der 2T2C-Zelle die Speicherzelle eine positive Polarisierung, so ist deren Referenzzelle negativ polarisiert. Wird nun die Speicherzelle mit einem positiven Leseimpuls ausgelesen, so kehrt sich die Polarisierung der Referenzzelle um, während der Zustand der Speicherzelle unverändert bleibt. Die Referenzzelle nimmt also in diesem Fall im Vergleich zu der Speicherzelle die größere Ladung auf. Die dadurch gegebene Ladungsdifferenz wird sodann durch den Leseverstärker bewertet.

Haben in einem ferroelektrischen Speicher einzelne Zellen ungenügende Datenhaltungseigenschaften oder wird ein Manipulationsversuch beispielsweise durch globale oder lokale Temperaturerhöhung vorgenommen, so verlieren die Dielektrika der betroffenen Zellen einen Teil ihrer Polarisierung, so daß die Zellen aus beiden Zuständen mit positiver bzw. negativer Polarisation auf eine "Null"-Polarisation, einen sogenannten Nullzustand, zustreben. Befindet sich nun eine Speicherzelle und ihre Referenzzelle durch eine Störung oder einen Manipulationsversuch im Nullzustand, so ist keine bewertbare Polarisationsdifferenz mehr vorhanden, und das Signal am Ausgang des Leseverstärkers ist nicht mehr vorhersagbar abhängig von Faktoren, wie beispielsweise Toleranzen, die mit dem Speicherinhalt nichts zu tun haben.

Es ist nun Aufgabe der vorliegenden Erfindung, eine Anordnung zur Auswertung eines aus einem ferroelektrischen Speicherkondensator ausgelesenen Signales so zu verbessern, daß die Datenhaltung in den einzelnen Zellen überwacht und eine versuchte Datenmanipulation durch beispielsweise einen lokalen oder globalen thermischen Angriff sofort festgestellt werden kann.

Diese Aufgabe wird bei einer Anordnung der eingangs genannten Art erfindungsgemäß dadurch gelöst, daß zwischen dem Leseverstärker und der Auswertelogik ein mit einem Taktsignal beaufschlagter Zähler vorgesehen ist, der die Pulsweite des vom Leseverstärker verstärkten ausgelesenen Signales in einem entsprechenden Zählerwert umsetzt, und daß die Auswertelogik aus der Höhe des Zählerwertes beurteilt, ob das Signal aus einem Bereich hoher positiver Polarisation, hoher negativer Polarisation oder schwacher Polarisation des Speichermediums des ferroelektrischen Speicherkondensators ausgelesen ist.

Bei der erfindungsgemäßen Anordnung wird so ein "dritter Bewertungszustand" eingeführt, der sich beiderseits des "Nullzustandes" befindet und von der Bewertung ausgeschlossen werden kann. Befindet sich der Polarisationszustand der Zelle beim Lesen innerhalb dieses dritten Bewertungszustandes, so kann der Leseverstärker ohne weiteres ein Signal liefern, das die Ungültigkeit der Ausgangsdaten signalisiert. Durch Auswertung weiterer Umstände mittels beispielsweise Monitorzellen kann dann die Auswertelogik ohne weiteres entscheiden, ob ein Datenhaltungsproblem oder ein Manipulationsversuch vorliegt, wenn der dritte Bewertungszustand im Leseverstärker festgestellt wird.

Zweckmäßigerweise wird die Breite des dritten Bewertungszustandes symmetrisch um den "Nullzustand" eingestellt.

Es ist vorteilhaft, wenn die Breite des dritten Bewertungszustandes einstellbar ist. Denn dann ist es möglich, einen Speicher optimal an die an ihn gestellten Anforderungen anzupassen. Eine große Breite des dritten Bewertungszustandes ist vor allem dann vorteilhaft, wenn die Gefahr von Manipulationsversuchen besteht, während eine kleinere Breite bei Anwendungen ausreicht, bei denen solche Manipulationsversuche nicht zu befürchten sind.

Schließlich ist noch zu beachten, daß mit der erfindungsgemäßen Anordnung eine Speicherzelle realisierbar ist, die 1,5 Bit in einem Speicherkondensator ablegen kann. Denn die Speicherzustände können durch positive Polarisierung, negative Polarisierung und keine Polarisierung ausgedrückt werden, so daß der "Nullzustand" zur Speicherung eines dritten Informationszustandes ausnutzbar ist. Hierzu ist allerdings eine geeignete Schaltung erforderlich, die es erlaubt, eine Zelle in einen "Nullzustand" zu bringen. Dies ist mittels einer Depolarisierungsschaltung möglich, bei der beispielsweise die Amplitude einer sinusförmigen Wechselspannung, die an der Zelle anliegt, kontinuierlich nach unten gefahren wird.

Nachfolgend wird die Erfindung anhand der Zeichnungen näher erläutert. Es zeigen:
- Fig. 1: eine Hysteresekurve einer ferroelektrischen Speicherzelle mit verschiedenen Polarisationszuständen,
- Fig. 2: ein Prinzipschaltbild zur Erläuterung des bei der erfindungsgemäßen Anordnung verwendeten Leseverstärkers,
- Fig. 3: ein Blockschaltbild der erfindungsgemäßen Anordnung,
- Fig. 4: ein Diagramm zur Erläuterung der Arbeitsweise des Leseverstärkers bei der Auswertung eines aus einer Speicherzelle ausgelesenen Signales, und
- Fig. 5: ein konkretes Schaltungsbeispiel für die erfindungsgemäße Anordnung.

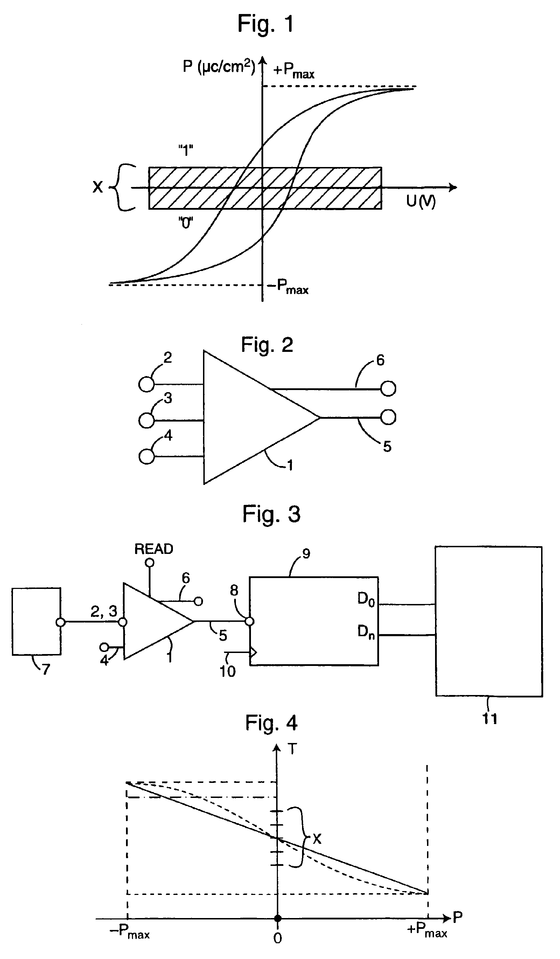

Fig. 1 zeigt eine Hysteresekurve, bei der die Polarisation P (µC/cm²) in Abhängigkeit von der Spannung U(V) aufgetragen ist. Eine positive Polarisation P bedeutet beispielsweise eine logische "1", während einer negativen Polarisation eine logische "0" zugeordnet ist.

Ein Nullzustand der Polarisation ist durch P = 0 gegeben. Beidseits des Nullzustandes ist in dessen unmittelbarer Nähe der Zustand einer Zelle nicht oder schwierig zu bewerten. Die Erfindung führt daher einen dritten Bewertungszustand X ein, der gemeldet und in welchem eine Bewertung nicht vorgenommen wird. Wird bei der Bewertung einer Speicherzelle eine Größe aus dem Bereich X erhalten, so bedeutet dies, daß beispielsweise durch einen thermischen Angriff eine Datenmanipulation versucht wurde oder die Datenhaltungseigenschaften des Speichers verschlechtert sind.

Die näheren Umstände, ob ein Verlust an Datenhaltungseigenschaft oder eine versuchte Datenmanipulation vorliegt, können durch die Auswertelogik festgestellt werden, wenn dieser weitere Informationen über den gegenwärtigen Zustand des Speichers zugeliefert werden.

Wesentlich an der erfindungsgemäßen Anordnung ist also zunächst, daß diese einen dritten Bewertungszustand, nämlich den Bereich X, bei der Auswertung des Lesesignales einer ferroelektrischen Zelle einführt.

Fig. 2 zeigt nun ein Blockschaltbild eines Leseverstärkers 1, der mehrere Pegel erfassen kann. Dieser Leseverstärker hat einen Eingang 2 für das Ausgangssignal von der Speicherzelle, einen Eingang 3 für das Ausgangssignal von der Referenzzelle und einen weiteren Eingang 4, mit dem dem Leseverstärker 1 ein Eingangssignal zugeführt werden kann, mit dem die Breite des Bereiches X oberhalb und unterhalb von der Linie P = 0 (vgl. Fig. 1) eingestellt werden kann. Durch diese Einstellbarkeit des Leseverstärkers 1 kann die erfindungsgemäße Anordnung optimal an die an sie angestellten Anforderungen mit beispielsweise hoher oder niedriger Sicherheit gegen Manipulationsversuche eingestellt werden.

Weiterhin ist es durch Ansteuerung des Einganges 4 möglich, eine Verteilung der erreichbaren Zellpolarisierungen direkt im Speicher bzw. "on-chip" vorzunehmen. Diese zuletzt genannte Funktion kann speziell während der Entwicklungsphase von Speichern ein umfangreiches Überwachen bzw. Monitoring erleichtern.

Der Leseverstärker 1 hat weiterhin einen Ausgangsanschluß 5 und einen Ausgangsanschluß 6, der dann ein Signal abgibt, wenn bei der Auswertung der über die Eingangsanschlüsse 2, 3 zugeführten Signale festgestellt wird, daß eines dieser Signale aus dem Bereich X resultiert. Damit ist es ohne weiteres möglich, sofort die Ungültigkeit der Ausgangsdaten zu signalisieren.

Fig. 3 zeigt nun ein Blockschaltbild der erfindungsgemäßen Anordnung mit einem Speicher bzw. einer Speicherzelle 7, der der Leseverstärker 1 mit einem zusätzlichen Leseausgang READ nachgeschaltet ist. Der Ausgangsanschluß 5 dieses Leseverstärkers ist mit dem Zähler-Freigabeanschluß bzw. Count Enable 8 eines Zählers 9 verbunden, an dessen Takteingangsanschluß 10 ein Taktsignal liegt. Der Zähler 9 zählt solange die über den Taktanschluß 10 zugelieferten Takte, wie ein Ausgangssignal von dem Leseverstärker 1 dem Takt-Freigabeanschluß 8 zugeführt ist. Über Ausgangsanschlüsse D₀ bis Dₙ des Zählers 9 werden die erhaltenen Ergebnisse einer Auswerteelektronik 11 zugeführt, die dann aus der im Zähler 9 ermittelten Pulsweite τ des Ausgangssignales des Leseverstärkers 1 feststellt, ob eine Polarisation im Bereich X ausgewertet wurde oder nicht. Diese Auswertung ist schematisch in Fig. 4 dargestellt, in der auf der Abszisse die Polarisation P aufgetragen ist, wobei Werte +Pₘₐₓ und -Pₘₐₓ Werten entsprechen, die jeweils den "Spitzen" der Hysteresekurve (vgl. Fig. 1) zugeordnet sind. Liegt die Pulsweite innerhalb des Bereiches X, so bedeutet dies das Auftreten eines Datenhaltungsproblemes bzw. eines Manipulationsversuches. Bei Pulsweiten außerhalb des Bereiches X liegen dagegen keine Datenhaltungsprobleme oder Manipulationsversuche vor.

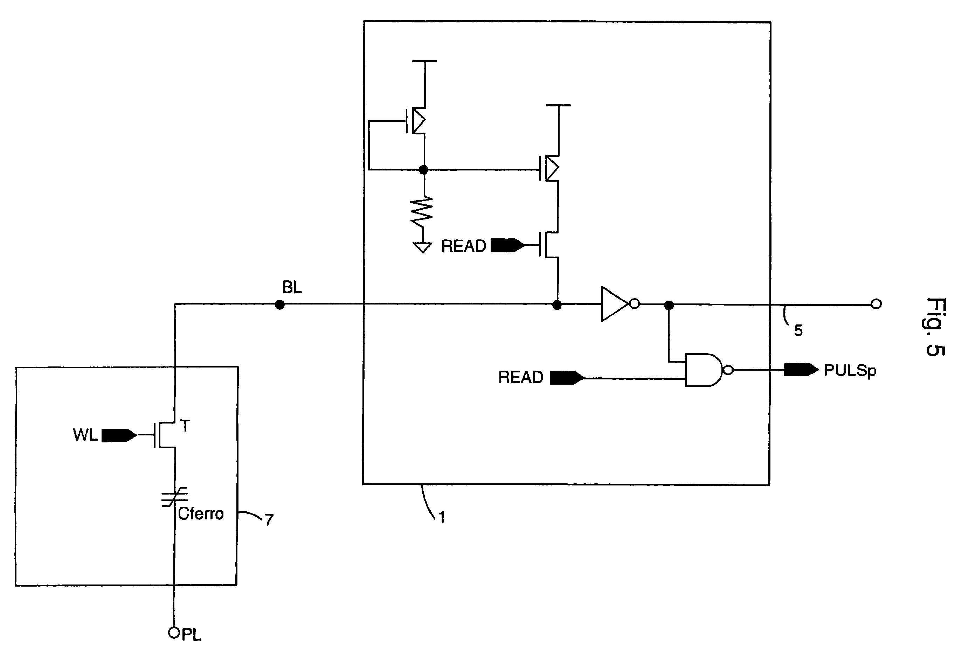

Fig. 5 zeigt schließlich ein konkretes Beispiel für die Speicherzelle 7 und den Leseverstärker 1.

Die Speicherzelle 7 besteht aus einem ferroelektrischen Speicherkondensator Cferro, an dessen einer Elektrode eine Plattenspannung PL liegt, während die andere Elektrode dieses Kondensators mit einem Auswahltransistor T verbunden ist, dessen Gateelektrode an eine Wortleitung WL angeschlossen ist. Der Ausgang des Auswahltransistors ist über eine Bitleitung BL mit dem Leseverstärker 1 verbunden, der in üblicher Weise aus n-Kanal- und p-Kanal-MOS-Transistoren, Widerständen, einem Inverter und einem NAND-Gatter aufgebaut ist.

Die Speicherzelle 7 wird durch Aktivieren der Wortleitung WL ausgewählt. Durch Einschalten der Leseleitung READ wird die Speicherzelle 7 gelesen. Abhängig von dem Polarisationszustand des Speicherkondensators Cferro entsteht dann an einem Anschluß PUSLp ein unterschiedlich langer negativer Spannungsimpuls.

## Patentansprüche

1. Anordnung zur Auswertung eines aus einem ferroelektrischen Speicherkondensator (Cferro) ausgelesenen Signales, mit einem Leseverstärker (1) zum Verstärken des ausgelesenen Signales und einer dem Leseverstärker (1) nachgeschalteten Auswertelogik (11),
**dadurch gekennzeichnet**, daß zwischen dem Leseverstärker (1) und der Auswerteelektronik (11) ein mit einem Taktsignal beaufschlagter Zähler (9) vorgesehen ist, der die Pulsweite des vom Leseverstärker (1) verstärkten ausgelesenen Signales in einen entsprechenden Zählerstand umsetzt, und daß die Auswertelogik (11) aus der Höhe des Zählerstandes beurteilt, ob das Signal aus einem Bereich hoher positiver Polarisation, hoher negativer Polarisation oder schwacher Polarisation des Speichermediums des ferroelektrischen Speicherkondensators Cferro ausgelesen ist.

2. Anordnung nach Anspruch 1,
**dadurch gekennzeichnet**, daß die Breite (X) des Bereiches schwacher Polarisation im Leseverstärker (1) einstellbar ist.

3. Anordnung nach Anspruch 1 oder 2,
**dadurch gekennzeichnet**, daß der Bereich schwacher Polarisation als weiterer Informationszustand auswertbar ist.

4. Anordnung nach einem der Ansprüche 1 bis 3,
**dadurch gekennzeichnet**, daß der Leseverstärker (1) mit einem zusätzlichen Ausgang (6) zum Melden des Zustandes schwacher Polarisation versehen ist.

5. Anordnung nach einem der Ansprüche 1 bis 4,
**dadurch gekennzeichnet**, daß der Bereich (X) schwacher Polarisation symmetrisch um den Nullzustand der Polarisation angeordnet ist.
